# EUROPEAN PATENT SPECIFICATION

(11) **EP 3 243 235 B1**
(45) Date of publication and mention of the grant of the patent: **26.03.2025**
(21) Application number: 15816998.7
(22) Date of filing: 03.12.2015
(51) Int. Cl.: H01M 10/02, H01M 10/48, H01M 10/60, H01M 10/65, H01M 50/103, H01M 50/569, H01M 50/147, H01M 50/209, H01M 50/30, H01M 50/342, H01M 50/367, H01M 50/55, H01M 50/50, H01M 50/524, H01M 10/6551, H01M 10/42, H01M 50/503, H01M 50/308, H01M 50/553

(54) **SNAP-IN EXTENSIONS AND GUIDE WALLS FOR BUS BAR BRIDGES OF A BATTERY MODULE**
EINRASTBARE VERLÄNGERUNGEN UND LEITWÄNDE SAMMELSCHIENENBRÜCKEN EINES BATTERIEMODULS
EXTENSIONS ENFICHABLES ET PAROIS DE GUIDAGE POUR DES PONTS DE BARRE OMNIBUS D'UN MODULE DE BATTERIE

(30) Priority: 05.01.2015 US 201562100001 P; 05.05.2015 US 201514704614
(43) Date of publication of application: 15.11.2017
(73) Proprietor: CPS Technology Holdings LLC, New York, New York 10281 (US)
(72) Inventor: MACK, Robert J., Milwaukee, Wisconsin 53212 (US); DEKEUSTER, Richard M., Racine, Wisconsin 53402 (US); CZARNECKI,Jennifer L., Franklin, Wisconsin 53132 (US); NAKAYAMA, Ken, Franklin, Wisconsin 53132 (US); TYLER, Matthew R., New York, NY 10021 (US); BONIN, Christopher M, South Milwaukee, Wisconsin 53172 (US); ZHANG, Xugang, Milwaukee, Wisconsin 53209 (US); TRESTER, Dale B., Milwaukee, Wisconsin 53222 (US); FUHR, Jason D., Sussex Wisconsin 53089 (US)
(74) Representative: Meissner Bolte Partnerschaft mbB
(86) International application number: PCT/US2015/063706
(87) International publication number: WO 2016/111779

(56) References cited:
- EP-A1- 2 698 846
- DE-A1- 102012 202 694
- JP-A- 2000 223 098
- JP-A- 2014 010 984

## Description

### BACKGROUND

The present disclosure relates generally to the field of batteries and battery modules. More specifically, the present disclosure relates to positioning and retention of bus bar bridges of a battery module.

This section is intended to introduce the reader to various aspects of art that may be related to various aspects of the present disclosure, which are described below. This discussion is believed to be helpful in providing the reader with background infomiation to facilitate a better understanding of the various aspects of the present disclosure. Accordingly, it should be understood that these statements are to be read in this light, and not as admissions of prior art.

A vehicle that uses one or more battery systems for providing all or a portion of the motive power for the vehicle can be referred to as an xEV, where the term "xEV" is defined herein to include all of the following vehicles, or any variations or combinations thereof, that use electric power for all or a portion of their vehicular motive force. For example, xEVs include electric vehicles (EVs) that utilize electric power for all motive force. As will be appreciated by those skilled in the art, hybrid electric vehicles (HEVs), also considered xEVs, combine an internal combustion engine propulsion system and a battery-powered electric propulsion system, such as 48 Volt (V) or 130V systems. The term HEV may include any variation of a hybrid electric vehicle. For example, full hybrid systems (FHEVs) may provide motive and other electrical power to the vehicle using one or more electric motors, using only an internal combustion engine, or using both. In contrast, mild hybrid systems (MBEVs) disable the internal combustion engine when the vehicle is idling and utilize a battery system to continue powering the air conditioning unit, radio, or other electronics, as well as to restart the engine when propulsion is desired. The mild hybrid system may also apply some level of power assist, during acceleration for example, to supplement the internal combustion engine. Mild hybrids are typically 96V to 130V and recover braking energy through a belt or crank integrated starter generator. Further, a micro-hybrid electric vehicle (mHEV) also uses a "Stop-Start" system similar to the mild hybrids, but the micro-hybrid systems of a mHEV may or may not supply power assist to the internal combustion engine and operates at a voltage below 60V. For the purposes of the present discussion, it should be noted that mHEVs typically do not technically use electric power provided directly to the crankshaft or transmission for any portion of the motive force of the vehicle, but an mHEV may still be considered as an xEV since it does use electric power to supplement a vehicle's power needs when the vehicle is idling with internal combustion engine disabled and recovers braking energy through an integrated starter generator. In addition, a plug-in electric vehicle (PEV) is any vehicle that can be charged from an external source of electricity, such as wall sockets, and the energy stored in the rechargeable battery packs drives or contributes to drive the wheels. PEVs are a subcategory of EVs that include all-electric or battery electric vehicles (BEVs), plug-in hybrid electric vehicles (PHEVs), and electric vehicle conversions of hybrid electric vehicles and conventional internal combustion engine vehicles.

xEVs as described above may provide a number of advantages as compared to more traditional gas-powered vehicles using only internal combustion engines and traditional electrical systems, which are typically 12V systems powered by a lead acid battery. For example, xEVs may produce fewer undesirable emission products and may exhibit greater fuel efficiency as compared to traditional internal combustion vehicles and, in some cases, such xEVs may eliminate the use of gasoline entirely, as is the case of certain types of EVs or PEVs,

As technology continues to evolve, there is a need to provide improved power sources, particularly battery modules, for such vehicles. For example, in traditional configurations, battery modules may include components configured to provide electrical communication between one or more terminals of the battery module and a group of electrically interconnected electrochemical cells of the battery module. Unfortunately, traditional configurations may include expensive components to provide the electrical communication (e.g., electrical path) between the group of electrically interconnected electrochemical cells and the one or more terminals of the battery module. Further, manufacturing processes to position said components and to enable the electrical communication may be expensive and inefficient Accordingly, it is now recognized that improved components and manufacturing processes for electrically coupling electrochemical cells and terminals of a battery module are desired.

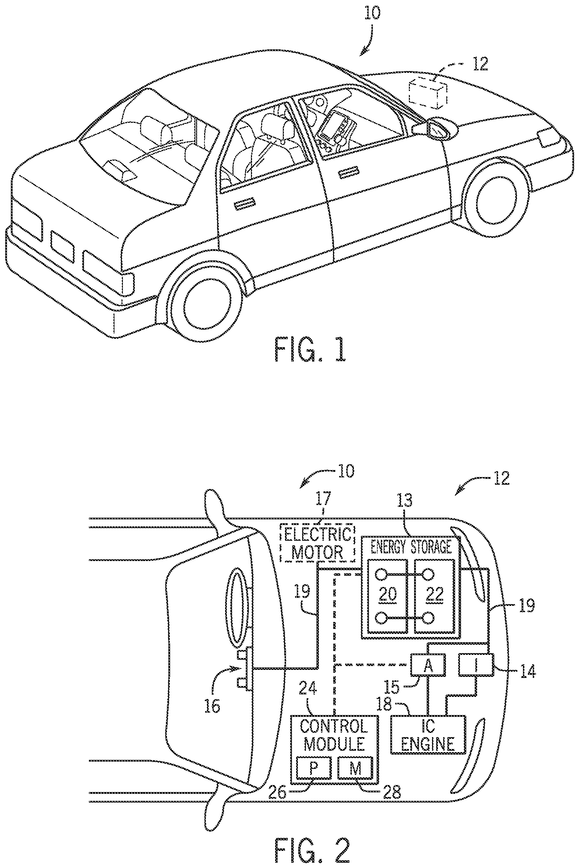

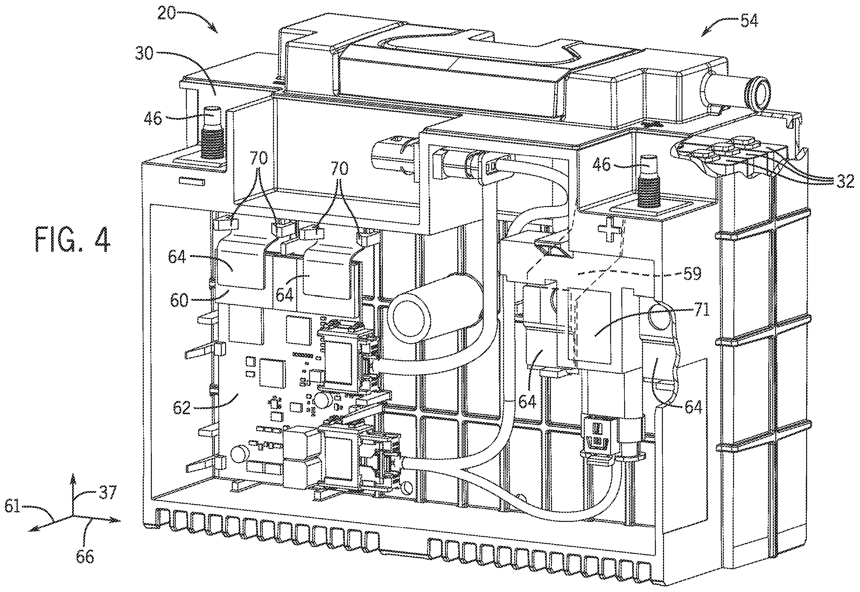

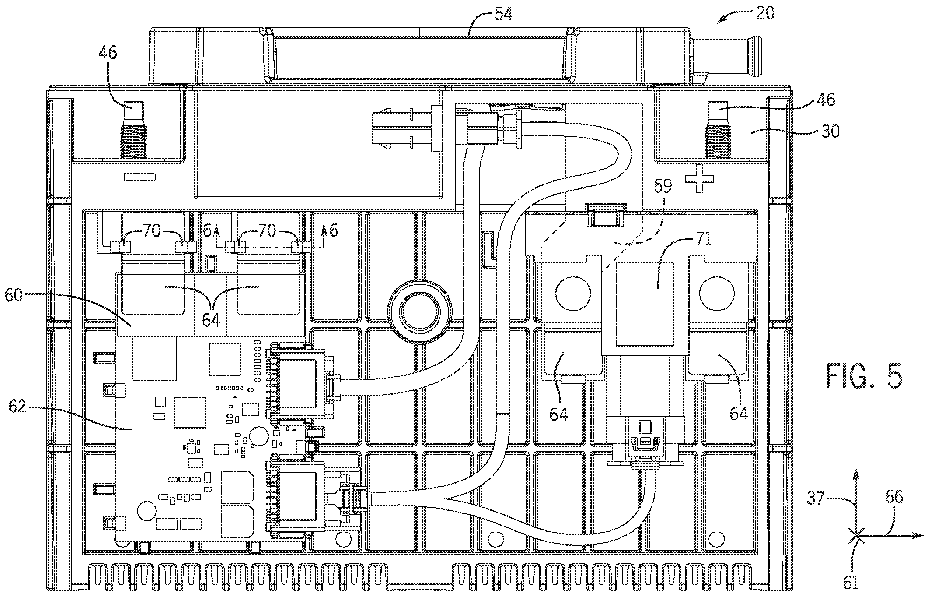

Document JP2014010984 represents a close prior disclosing a lithium-ion (Li-ion) battery module (2), comprising:
- a group of electrically interconnected electrochemical cells (1, see paragraph [0025]);
- a battery module terminal (see terminals + and
- on the lid (10) in figure 1) configured to be coupled to a load for powering the load;
- an electrical path extending between the group of electrically interconnected electrochemical cells and the battery module terminal (system of bus bars (6) as shown in figure 5), wherein the electrical path comprises a bus bar bridge (anyone of the bus bar (6), since any bus bar (6) bridges two cells) coupled between the battery module terminal and a plurality of bus bars (e.g. the fifth bus bar bridge (6) from the bottom of the battery module shown in figure 4) configured to electrically interconnect the group of electrically interconnected electrochemical cells; and
- a housing (elements 3, 5 and 10), wherein the group of electrically interconnected electrochemical cells is disposed within the housing.

### SUMMARY

A summary of certain embodiments disclosed herein is set forth below. It should be understood that these aspects are presented merely to provide the reader with a brief summary of certain embodiments and that these aspects are not intended to limit the scope of this disclosure. Indeed, this disclosure may encompass a variety of aspects that may not be set forth below.

The present disclosure relates to a battery module having a group of electrically interconnected electrochemical cells, a battery module terminal configured to be coupled to a load for powering the load, and an electrical path extending between the group of electrically interconnected electrochemical cells and the battery module terminal, where the electrical path includes a bus bar bridge. The battery module also includes a housing, where the group of electrically interconnected electrochemical cells is disposed within the housing, and the housing includes a pair of extensions positioned along sides of the bus bar bridge and configured to retain the bus bar bridge and to block movement of the bus bar bridge in at least one direction.

The present disclosure also relates a battery module having a housing, electrochemical cells disposed in the housing, a major terminal, and an electrical path extending between the electrochemical cells and the major terminal. The electrical path includes an S-shaped bus bar bridge having a first base, a second base, and all S-bend extending between the first and second bases. The housing includes a first extension extending upwardly and proximate to a first side of the S-shaped bus bar bridge, and a second extension extending upwardly and proximate to a second side of the S-shaped bus bar bridge opposite to the first side. The first and second extensions are configured to block movement of the S-shaped bus bar bridge along at least one axis of the S-shaped bus bar bridge.

The present disclosure also relates to a battery module having an electrical path extending between a group of electrically interconnected electrochemical cells and a terminal of the battery module, where the terminal is configured to be coupled to a load for powering the load. The battery module also includes a bus bar bridge of the electrical path. Further, the battery module includes at least one snap-in extension integrally formed with a housing of the battery module and disposed immediately adjacent the bus bar bridge, wherein the at least one snap-in extension comprises a hook extending over the bus bar bridge and the at least one snap-in extension is configured to at least temporarily block movement of the bus bar bridge in at least one direction.

### DRAWINGS

Various aspects of this disclosure may be better understood upon reading the following detailed description and upon reference to the drawings in which:
FIG. 1 is a perspective view of a vehicle having a battery system configured in accordance with present embodiments to provide power for various components of the vehicle;
FIG. 2 is a cutaway schematic view of an embodiment of the vehicle and the battery system of FIG. 1,
FIG. 3 is an overhead exploded perspective view of an embodiment of a battery module for use in the vehicle of FIG. 1, in accordance with an aspect of the present disclosure;
FIG. 4 is a perspective view of an embodiment of the battery module of FIG. 3, in accordance with an aspect of the present disclosure;
FIG. 5 is a front view of **an** embodiment of the battery module of FIG. 3, in accordance with an aspect of the present disclosure;
FIG. 6 is a front schematic view of an embodiment of snap-in extensions and a bus bar bridge, taken along line 6-6 in FIG. 5, for use in the battery module of FIG. 3, in accordance with an aspect of the present disclosure;
FIG. 7 is a side schematic view of an embodiment of snap-in extensions, a bus bar bridge, and other components for use in the battery module of FIG. 3, in accordance with an aspect of the present disclosure;
FIG. 8 is a front schematic view of an embodiment of guide walls and a bus bar bridge for use in the battery module of FIG. 3, in accordance with an aspect of the present disclosure;
FIG. 9 is a side schematic view of an embodiment of guide walls, a bus bar bridge, and other components for use in the battery module of FIG. 3, in accordance with an aspect of the present disclosure;
FIG. 10 is a top schematic view of an embodiment of a bus bar bridge, in accordance with an aspect of the present disclosure; and
FIG. 11 is a schematic view of an embodiment of an electrical path for use in the battery module of FIG. 3, in accordance with an aspect of the present disclosure; and
FIG. 12 is a process flow diagram of an embodiment of a method of securitig a bus bar bridge of the battery module of FIG. 3, in accordance with an aspect of the present disclosure.

### DETAILED DESCRIPTION

One or more specific embodiments will be described below, while the invention is disclosed in the appended claims. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

The battery systems described herein may be used to provide power to various types of electric vehicles (xEVs) and other high voltage energy storage/expending applications (e.g., electrical grid power storage systems). Such battery systems may include one or more battery modules, each battery module having a number of battery cells (e.g., lithium-ion (Li-ion) electrochemical cells) arranged and electrically interconnected to provide particular voltages and/or currents useful to power, for example, one or more components of an xEV. As another example, battery modules in accordance with present embodiments may be incorporated with or provide power to stationary power systems (e.g., non-automotive systems).

In accordance with embodiments of the present disclosure, the battery module may include a group of electrically interconnected electrochemical cells disposed in a housing of the battery module. The battery module may also include two terminals (e.g, module terminals or major terminals) extending outwardly from the housing and configured to be coupled to a load for powering the load. Two corresponding electrical paths may be defined between the group of electrically interconnected electrochemical cells and the two corresponding terminals of the battery module. For example, a first electrical path may be established between the group of electrically interconnected electrochemical cells and a first terminal (e.g, a first major terminal) of the battery module. A second electrical path may be established between the group of electrically interconnected electrochemical cells and a second terminal (e.g. a second major terminal) of the battery module,

In certain embodiments, the electrical paths between the group of electrically interconnected electrochemical cells and the two terminals of the battery module may include corresponding transitions between a first and second material. For example, the electrochemical cells may be electrically interconnected via bus bars that include the first material (e.g., aluminum). The two major terminals (and/or other components of the battery module, such as a shunt) that are configured to be coupled to the load may include the second material (e.g., copper), which may cost less than the first material but may not be compatible with the electrochemical cells and thus, may not be used for the bus bars, Accordingly, components that enable the transition between the first and second materials (e.g., of the bus bars and of the major terminals, respectively) may be included in both of the first and second electrical paths. For example, a bi-metal bus bar may be disposed in both the first and second electrical paths to enable the transition from the first material (of the bus bars) to the second material (of the major terminals) in each of the paths. The bi-metal bus bars may be bi-metallic, and may each include a first end having the first material and coupled to a first component (e.g., a terminal of one of the electrochemical cells or a bus bar extending from one of the terminals of one of the electrochemical cells) of the electrical path having the first material, and a second end having the second material and coupled to a second component (e.g., a bus bar bridge) of the electrical path having the second material. The bus bar bridges of each electrical path may extend between the corresponding bi-metal bus bar and another corresponding component of the battery module (e.g., a shunt or relay having the second material). Additional bus bar bridges having the second material may also be included in each electrical path, as set forth below with reference to the figures, to couple the electrical paths with the major terminals having the second material.

To couple the bus bar bridges to the appropriate components of the electrical paths, the bus bar bridges may be welded at either end (e.g., to the bi-metal bus bar on a first end and to the shunt or relay on a second end, as described above). However, to enable efficient manufacturing of the battery module, in accordance with present embodiments, the housing of the battery module may include snap-in extensions or guide walls that enable temporary retention of the bus bar bridges or support for the bus bar bridges in one or more directions. For example, the snap-in extensions or guide walls may be integrally formed with the housing of the battery module, and may be configured to receive the bus bar bridges and to enable retention of the bus bar bridges (e.g., by blocking movement of the bus bar bridges in one or more directions), while facilitating exposure of weld points of the bus bar bridges to a welding tool. In other words, in certain embodiments, the snap-in extensions or guide walls may enable retention of the bus bar bridges while the battery module is oriented in the one or more directions. Thus, the bus bar bridges may be held in place while the battery module is oriented complimentary to the retention capabilities of the snap-in extensions or guide posts and complimentary to the positioning of a welding tool along the weld points of the bus bar bridges for welding the bus bar bridges to appropriate components of the electrical paths. Further, the retention mechanisms (e.g., the snap-in features) may be minimally invasive (e.g., via sizing and/or positioning of the retention mechanisms), such that a welding tool may access weld points on the bus bar bridges to more permanently secure the bus bar bridges in the electrical path(s).

To help illustrate, FIG. 1 is a perspective view of an embodiment of a vehicle 10, which may utilize a regenerative braking system. Although the following discussion is presented in relation to vehicles with regenerative braking systems, the techniques described herein are adaptable to other vehicles that capture/store electrical energy with a battery, which may include electric-powered and gas-powered vehicles.

As discussed above, it would be desirable for a battery system 12 to be largely compatible with traditional vehicle designs. Accordingly, the battery system 12 may be placed in a location in the vehicle 10 that would have housed a traditional battery system. For example, as illustrated, the vehicle 10 may include the battery system 12 positioned similarly to a lead-acid battery of a typical combitstion-engine vehicle (e.g., under the hood of the vehicle 10). Furthermore, as will be described in more detail below, the battery system 12 may be positioned to facilitate managing temperature of the battery system 12. For example, in some embodiments, positioning a battery system 12 under the hood of the vehicle 10 may enable an air duct to channel airflow over the battery system 12 and cool the battery system 12.

A more detailed view of the battery system 12 is described in FIG. 2. As depicted, the battery system 12 includes an energy storage component 13 coupled to an ignition system 14, an alternator 15, a vehicle console 16, and optionally to an electric motor 17. Generally, the energy storage component 13 may capture/store electrical energy generated in the vehicle 10 and output electrical energy to power electrical devices in the vehicle 10.

In other words, the battery system 12 may supply power to components of the vehicle's electrical system, which may include radiator cooling fans, climate control systems, electric power steering systems, active suspension systems, auto park system, electric oil pumps, electric super/turbochargers, electric water pumps, heated windscreen/defrosters, window lift motors, vanity lights, tire pressure monitoring system, sunroof motor controls, power seats, alarm system, infotainment system, navigation features, lane departure warning systems, electric parking brakes, external lights, or any combination thereof. Illustratively, in the depicted embodiment, the energy storage component 13 supplies power to the vehicle console 16 and the ignition system 14, which may be used to start (e.g., crank) the internal combustion engine 18.

Additionally, the energy storage component 13 may capture electrical energy generated by the alternator 15 and/or the electric motor 17. In some embodiments, the alternator 15 may generate electrical energy while the internal combustion engine 18 is running. More specifically, the alternator 15 may convert the mechanical energy produced by the rotation of the internal combustion engine 18 into electrical energy. Additionally or alternatively, when the vehicle 10 includes an electric motor 17, the electric motor 17 may generate electrical energy by converting mechanical energy produced by the movement of the vehicle 10 (e.g., rotation of the wheels) into electrical energy. Thus, in some embodiments, the energy storage component 13 may capture electrical energy generated by the alternator 15 and/or the electric motor 17 during regenerative braking. As such, the alternator 15 and/or the electric motor 17 are generally referred to herein as a regenerative braking system.

To facilitate capturing and supplying electric energy, the energy storage component 13 may be electrically coupled to the vehicle's electric system via a bus 19. For example, the bus 19 may enable the energy storage component 13 to receive electrical energy generated by the alternator 15 and/or the electric motor 17. Additionally, the bus 19 may enable the energy storage component 13 to output electrical energy to the ignition system 14 and/or the vehicle console 16. Accordingly, when a 12 volt battery system 12 is used, the bus 19 may carry electrical power typically between 8-18 volts.

Additionally, as depicted, the energy storage component 13 may include multiple battery modules. For example, in the depicted embodiment, the energy storage component 13 includes a lithium ion (e.g., a first) battery module 20 and a lead-acid (e.g., a second) battery module 22, which each includes one or more battery cells. In other embodiments, the energy storage component 13 may include any number of battery modules. Additionally, although the lithium ion battery module 20 and lead-acid battery module 22 are depicted adjacent to one another, they may be positioned in different areas around the vehicle. For example, the lead-acid battery module 22 may be positioned in or about the interior of the vehicle 10 while the lithium ion battery module 20 may be positioned under the hood of the vehicle 10.

In some embodiments, the energy storage component 13 may include multiple battery modules to utilize multiple different battery chemistries. For example, when the lithium ion battery module 20 is used, performance of the battery system 12 may be improved since the lithium ion battery chemistry generally has a higher coulombic efficiency and/or a higher power charge acceptance rate (e.g., higher maximum charge current or charge voltage) than the lead-acid battery chemistry. As such, the capture, storage, and/or distribution efficiency of the battery system 12 may be improved.

To facilitate controlling the capturing and storing of electrical energy, the battery system 12 may additionally include a control module 24. More specifically, the control module 24 may control operations of components in the battery system 12, such as relays (e.g., switches) within energy storage component 13, the alternator 15, and/or the electric motor 17. For example, the control module 24 may regulate amount of electrical energy captured/supplied by each battery module 20 or 22 (e.g., to de-rate and re-rate the battery system 12), perform load balancing between the battery modules 20 and 22, determine a state of charge of each battery module 20 or 22, determine temperature of each battery module 20 or 22, control voltage output by the alternator 15 and/or the electric motor 17, and the like.

Accordingly, the control unit 24 may include one or more processor 26 and one or more memory 28, More specifically, the one or more processor 26 may include one or more application specific integrated circuits (ASICs), one or more field programmable gate arrays (FPGAs), one or more general purpose processors, or any combination thereof. Additionally, the one or more memory 28 may include volatile memory, such as random access memory (RAM), and/or non-volatile memory, such as read-only memory (ROM), optical drives, hard disc drives, or solid-state drives. In some embodiments, the control unit 24 may include portions of a vehicle control unit (VCU) and/or a separate battery control module.

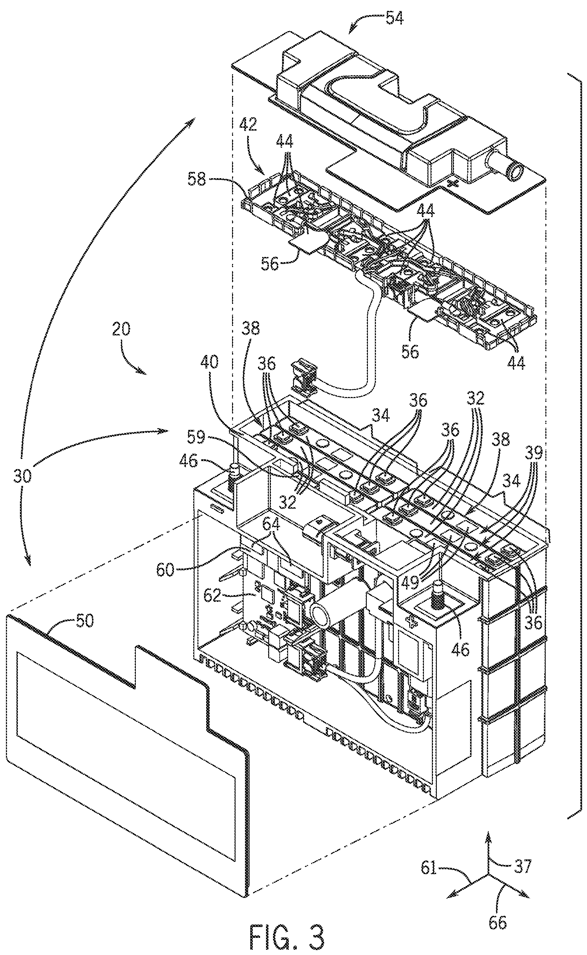

An overhead exploded perspective view of an embodiment of the battery module 20 for use in the vehicle 10 of FIG. 2 is shown in FIG. 3. In the illustrated embodiment, the battery module 20 (e.g, lithium-ion [Li-ion] battery module) includes a housing 30 and electrochemical cells 32 (e.g, prismatic lithium-ion [Li-ion] electrochemical cells) disposed inside the housing 30. In the illustrated embodiment, six prismatic Li-ion electrochemical cells 32 are disposed in two stacks 34 within the housing 30, three electrochemical cells 32 in each stack 34. However, in other embodiments, the battery module 20 may include any number of electrochemical cells 32 (e.g., 2, 3, 4, 5, 6, 7, 8, 9, 10, or more electrochemical cells), any type of electrochemical cell 32 (e.g., Li-ion, lithium polymer, lead-acid, nickel cadmium, or nickel metal hydride, prismatic, and/or cylindrical), and any arrangement of the electrochemical cells 32 (e.g,, stacked, separated, or compartmentalized).

As shown, the electrochemical cells 32 may include terminals 36 (e.g., cell terminals, minor terminals) extending upwardly (e.g., in direction 37). Accordingly, the terminals 36 may extend into an opening 38 disposed in an upper side 40 or face of the housing 30. For example, the electrochemical cells 32 may be inserted into the housing 30 through the opening 38 in the upper side 40, and positioned within the housing 30 such that the terminals 36 of the electrochemical cells 32 are disposed in the opening 38. A bus bar carrier 42 may be disposed into the opening 38 and may retain bus bars 44 disposed thereon and configured to interface with the terminals 36 of the electrochemical cells 32. For example, the bus bars 44 may interface with the terminals 36 to electrically couple adjacent electrochemical cells 32 together (e.g., to form a group of electrically interconnected electrochemical cells 32). The bus bars 44 may be mounted or disposed on or proximate to a top or a bottom face or surface of the bus bar carrier 42 (e.g., facing away from the electrochemical cells 32 or facing the electrochemical cells 32). However, in other embodiments, the battery module 20 may not include the bus bar carrier 42 and the bus bars 44 may be disposed directly onto the terminals 36,

Depending on the embodiment, the bus bars 44 may couple the electrochemical cells 32 in series, in parallel, or some of the electrochemical cells 32 in series and some of the electrochemical cells 32 in parallel. In general, the bus bars 44 enable a group of electrically interconnected electrochemical cells 32. Further, certain of the bus bars 44 may be configured to enable electrical coupling of the group of electrically interconnected electrochemical cells 32 with major terminals 46 (e.g., module terminals) of the battery module 20, where the major terminals 46 are configured to be coupled to a load (e.g., component(s) of the vehicle 10) to power the load. A cover 54 may be disposed over the bus bar carrier 42 to seal the opening 38 in the housing 30 of the battery module 20 and/or to protect the bus bars 44, other components disposed on the bus bar carrier 42 and/or other components of the battery module 20.

In accordance with present embodiments, the bus bars 44 (e.g., disposed on the bus bar carrier 42) may include two major bus bars 56 configured to enable electrical communication between the group of electrically interconnected electrochemical cells 32 and the major terminals 46. For example, the two major bus bars 56 may extend beyond a perimeter 58 of the bus bar carrier 42 (e.g, in direction 6I) and may each define at least a portion of a corresponding electrical path between the group of electrically interconnected electrochemical cells 32 and the major terminals 46. The major bus bars 56 may include a first material (e.g., aluminum) corresponding with a material of the terminals 36 of the electrochemical cells 32 and with the bus bars 44 (e.g., minor bus bars or cell bus bars). In accordance with present embodiments, each major bus bar 56 may extend from the group of electrically interconnected electrochemical cells 32 toward another component of the corresponding electrical path extending between the group of electrically interconnected electrochemical cells 32 and the corresponding major terminal 46.

For example, the major bus bars 56 may each extend toward a corresponding bi-metal bus bar 59 that facilitates transition of the electrical path from the first material (e.g., aluminum) to a second material (e.g., copper), which will be described in detail with reference to later figures. In the illustrated embodiment, only one bi-metal bus bar 59 is shown in one of the electrical paths, although it should be noted that the other of the electrical paths may also include the bi-metal bus bar 59. As shown, the bi-metal bus bar 59 may be coupled on a first end to the major bus bar 56, and on a second end to another component of the electrical path. For example, in the illustrated embodiment, one of the electrical paths (e.g., having the illustrated bi-metal bus bar 59) includes a shunt 60 coupled to a printed circuit board (PCB) 62 of the battery module 20, where the shunt 60 includes the second material (e.g., copper) and the PCB 62 detects in the shunt 60 a voltage, a temperature, and/or other important parameters of the electrical path and the battery module 20 in general. In accordance with present embodiments, bus bar bridges 64 having the second material (e.g., copper) may be included in the electrical path on either end of the shunt 60. For example, one bus bar bridge 64 extends between, and couples to, the second end (e.g., copper end) of the bi-metal bus bar 59 and the shunt 60. It should be noted that the coupling of the bus bar bridge 64 to the bi-metal bus bar 59 is blocked from view in the illustrated embodiment by the housing 30. Another bus bar bridge 64 extends between, and couples to, the shunt 60 and another component of the electrical path (e.g., the major terminal 46 or a connecting piece between the bus bar bridge 64 and the major terminal 46). It should be noted that the coupling of the bus bar bridge 64 and the other component of the electrical path (e.g., the major terminal 46 or connecting piece between the major terminal 46 and the bus bar bridge 64) is blocked from view in the illustrated embodiment by the housing 30.

In accordance with the present disclosure, the bus bar bridges 64 may be at least temporarily retained (e.g., before being welded to the components of the electrical path described above) via snap-in extensions or guide walls extending from the housing 30 (e.g., integrally formed with the housing 30), where the snap-in extensions or guide walls block movement of the bus bar bridges 64 in at least one direction or along one axis (e.g., along axis 37 [longitudinal axis with respect to the bus bar bridges 64], axis 61 [axis along a thickness of the bus bar bridges 64), or axis 66 [axis along the width of the bus bar bridges 64]). It should be noted that the bus bar bridges 64 may couple to a component of the battery module 20 other than the PCB 62 (e.g., to a relay or switch). For example, in the illustrated embodiment, the bus bar bridges 64 are only shown for one of the electrical paths, but the other electrical path may include bus bar bridges 64 coupled to a relay or switch. It should also be noted that, in other embodiments, the electrical paths may include other components that facilitate transition between the first and the second materials, and that the bus bar bridges 64 may couple to such other components.

Turning now to FIGS. 4 and 5, a perspective view and a front view, respectively, of an embodiment of the battery module 20 of FIG. 3 is shown. In the illustrated embodiments, as previously described, the shunt 60 of one of the electrical paths may be coupled to the PCB 62, where the PCB 62 (or signals of the PCB 62 or of the battery module 20) detects and/or analyzes operating parameters or conditions of the battery module 20 (e.g., of the electrical path having the shunt 60). The electrical path also includes the bus bar bridges 64, which electrically couple the shunt 60 to the electrically interconnected electrochemical cells 32 within the housing 30 of the battery module 20 and to the major terminal 46 of the battery module 20 (e.g., the major terminal 46 configured to be coupled to a load). Further, as previously described, the housing 30 may include snap-in extensions 70 (or guide walls) through which the bus bar bridges 64 extend, where the snap-in extensions 70 retain the bus bar bridges 64 (e.g., block movement of the bus bar bridges 64) in one or more directions (e.g., along axis 37, axis 61, axis 66, or a combination thereof).

As shown in the illustrated embodiments, the battery module 20 may include one electrical path for each major terminal 46. For example, as shown, one electrical path extends through the shunt 60 coupled to the PCB 62, while the other electrical path extends through a relay 71 of the battery module 20. The relay 71 may be a switch (or include a switch mechanism) that enables coupling and decoupling of the electrical path. For example, the switch mechanism of the relay 71 may be opened to disconnect the circuit between the two major terminals 46 (and having the group of electrically interconnected electrochemical cells 32 and two electrical paths) of the battery module 20. The switch mechanism of the relay 71 may be closed to connect the circuit between the two major terminals 46 of the battery module 20. The electrical path having the relay 71 (or coupled to the relay 71) may also include bus bar bridges 64, where the bus bar bridges 64 extend from either end of the relay 71 or component of the relay 71. Thus, the electrical path extends from the electrochemical cells 32, through the bi-metal bus bar 59, through one of the bus bar bridges 64, through the relay 71 (or component thereof), through the other one of the bits bar bridges 64, and to the major terminal 46.

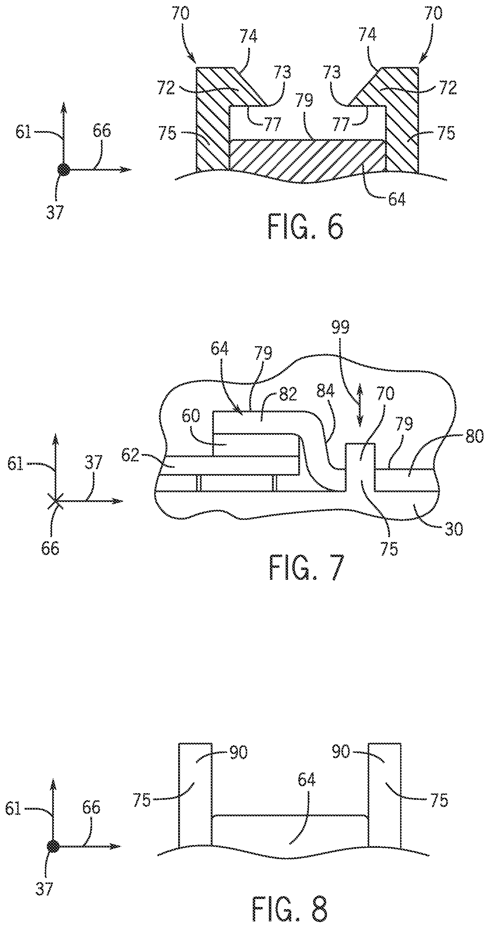

It should be noted that the snap-in extensions 70 may include hooks 72 that extend inwardly and over the bus bar bridge 64. For example, a cross-sectional schematic view of an embodiment of a pair of snap-in extensions 70, taken along line 6-6 in FIG. 5 and for use in the battery module 20 of FIG. 3, is shown in FIG. 6. In the illustrated embodiment, each snap-in extension 70 includes a hook 72 (e.g., triangle, right triangle, triangular prism, point, pointed hook) extending toward the other extension 70 of the pair. For example, each hook 72 may include a point 73 that points toward the other extension 70. Put differently, each hook 72 may be triangular (e.g., a right triangle) having a downwardly and inwardly sloping surface 74 that slopes toward the point 73. The surface 74 may enable pushing of the bus bar bridge 64 through the surface 74 and into place under a lower flat surface 77 of each hook 72, where the lower flat surface 77 of each hook 72 may be substantially parallel with a top surface 79 of the bus bar bridge 64. Further, the hooks 72 may facilitate retention of the bus bar bridge 64 (e.g., by blocking movement of the bus bar bridge 64), at least temporarily, in direction 61. Wall posts 75 of the snap-in extensions 70 may facilitate retention of the bus bar bridge 64 (e.g., by blocking movement of the bus bar bridge 64), at least temporarily, along direction 66.

A side schematic view of an embodiment of the snap-in extensions 70, bus bar bridge 64, shunt 60, and PCB 62 is shown in FIG. 7. In the illustrated embodiment, the bus bar bridge 64 is S-shaped and includes a first base 80, a second base 82, and an S-bend 84 extending between the first base 80 and the second base 82. The first base 80 is configured to be coupled (e.g., welded) to a component (not shown) of the electrical path (e.g., as described with reference to FIGS. 3-5), The second base 82, as previously described, may be configured to be coupled (e.g., welded) to the shunt 60. In the illustrated embodiment, the snap-in extensions 70 are generally disposed proximate to (e.g., in-line with) the first base 80 along direction 37. However, in other embodiments, the snap-in extensions 70 may be disposed proximate to (e.g in-line with) the S-bend 84 of the bus bar bridge 64, the second base 82 of the bus bar bridge 64, the first base 80 (as described above), or a combination thereof. In general, the snap-in extensions 70 retain (e.g., block at least some movement of) the bus bar bridge 64 in at least one direction (e.g., direction 66, direction 37, direction 61, or a combination thereof). For example, the snap-in extensions 70 may block at least some movement of the bus bar bridge 64 via the hooks 72 (shown in FIG. 6) contacting the upper surface 79 (shown in FIG.7) of the bus bar bridge 64 (e.g., along direction 61), via the hooks 72 (shown in FIG. 6) contacting the S-bend 84 (shown in FIG. 7) of the bus bar bridge 64 (e.g., along direction 37), and via the snap-in extensions 70 contacting sides of the bus bar bridge 64 (e.g., along direction 66). However, in some embodiments, as indicated by arrow 99 (shown in FIG. 7), the snap-in extensions 70 may extend above the upper surface 79 of the bus bar bridge 64 and above the S-bend 84, such that the S-bend 84 would not contact the hooks 72 (shown in FIG. 6) if slid along direction 37. In such embodiments, the snap-in extensions 70 may only block movement of the bus bar bridge 64 in directions 66 and 61.

It should be noted that, in some embodiments, guide walls 90 (e.g., extensions) may be included in place of, or in addition to, snap-in extensions 70. For example, a cross-sectional schematic view of the guide walls 90 and a portion of the bus bar bridge 64 is shown in FIG, 8. In the illustrated embodiment, the guide walls 90 include only the wall posts 75 (e.g without the hooks). Thus, the guide walls 90 may only block movement (at least temporarily) of the bus bar bridge 64 in direction 66. However, in another embodiment, the guide walls 90 may include the hooks (e.g., the hooks 72 in FIGS. 3-7), and, thus, may be referred to as snap-in extensions in embodiments having the hooks. Further, it should be noted that "extensions" encompasses both the snap-in extensions 70 and the guide walls 90.

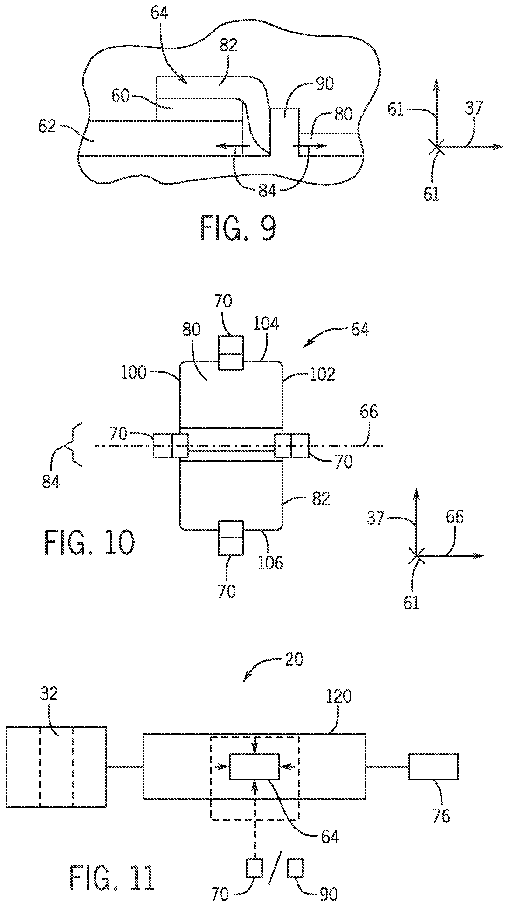

A side schematic view of the guide walls 90 is shown in FIG. 9. In the illustrated embodiment, the guide walls 90 are disposed proximate to (e.g., in-line with) the S-bend 84, However, the guide walls 90 may be disposed proximate to (e.g., in-line with) any portion of the bus bar bridge 64, including the S-bend 84, the first base 80, the second base 82, or a combination thereof.

It should also be noted that, in certain embodiments, the guide walls 90 (or snap-in extensions 70) may not be included in pairs and/or may be included along other surfaces of the bus bar bridge 64. For example, a schematic top view of the bus bar bridge 64 is shown in FIG. 10, In the illustrated embodiment, the bus bar bridge 64 includes two longitudinal sides 100, 102 extending along the first base 80, the S-bend 84, and the second base 82 of the bus bar bridge 64. The bus bar bridge also includes two transverse sides 104, 106 extending between the longitudinal sides 100, 102, where the first transverse side 104 extends along the first base 80 of the bus bar bridge 64 and the second transverse side 106 extends along the second base 82 of the bus bar bridge 64. One or more guide walls 90 or snap-in extensions 70 may be included along any one of the longitudinal sides 100, 102 and/or transverse sides 104, 106,

It should be noted that, in the illustrated embodiment, the bus bar bridge 64 is sized and shaped such that the bus bar bridge 64, if rotated 180 degrees about axis 66, is substantially positioned the same and capable of its same intended function and contiectibility as it was prior to rotating the bus bar bridge 64 180 degrees about axis 66. In other words, because of the S-shaped nature of the bus bar bridge 64, the bits bar bridge 64 may be flipped 180 degrees about axis 66 and would still fit into place in the electrical path. This feature increases ease of manufacturing and interchangeability of parts. It should also be noted that, in accordance with present embodiments, all of the bus bar bridge 64 of one electrical path may be substantially the same in shape and size. This feature also enables increased ease of manufacturing and interchangeability of parts. In some embodiments, all of the bus bar bridges 64 of the entire battery module 20 may be interchangeable.

A schematic view of an embodiment of an electrical path 120 of the battery module 20 is shown in FIG. 11. The electrical path 120 extends between one electrochemical cell 32 or two or more electrically interconnected electrochemical cells 32 (e.g., illustrated optionally as dashed lines) and one major terminal 76 (e.g., module terminal) of the battery module 20. In the illustrated embodiment, the electrical path 120 includes the bus bar bridge 64, and may include any number of other components. The illustrated embodiment also includes one or more snap-in extensions 70 and/or guide walls 90. As shown, the snap-in extensions 70 and/or guide walls 90 may be disposed along any side or surface of the bus bar bridge 64. It should also be noted that more than one bus bar bridge 64 and corresponding snap-in extensions 70 and/or guide walls 90 may be included, as previously described. The snap-in extensions 70 and/or guide walls 90 provide at least temporary retention of the bus bar bridge(s) 64 before, during, and/or after welding of the bus bar bridge(s) into place in the electrical path 120.

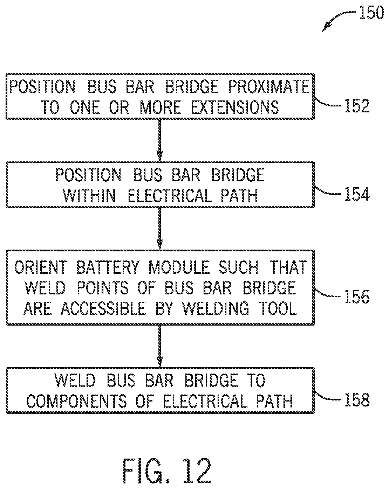

A process flow diagram of an embodiment of a method 150 of securing the bus bar bridge 64 of the battery module 20 of FIG. 3 is shown in FIG. 12. The method 150 includes positioning the bus bar bridge 64 proximate to one or more extensions (e.g., the snap-in extensions 70 or the guide walls 90) (block 152). For example, the bus bar bridge 64 may be positioned between a pair of extensions, where the extensions block movement of the bus bar bridge 64 in at least one direction.

The method 150 also includes positioning the bus bar bridge 64 within the electrical path 120 (block 154). For example, the bus bar bridge 64 may be positioned within the electrical path 120 such that the bus bar bridge 64 is in position to be welded to one or more components (e.g, the bi-metal bus bar 59, the shunt 60, the relay 71, or some other component of the electrical path 120). Indeed, the bus bar bridge 64 may be positioned in contact with the one or more components of the electrical path 120.

Further, the method 150 includes orienting the battery module 20 such that weld points of the bus bar bridge 64 are accessible by a welding tool (block 156). For example, as previously described, the extensions (e.g., the snap-in extensions 70 and/or the guide walls 90) may be positioned such that weld points of the bus bar bridge 64 are accessible by the welding tool, and such that the bus bar bridge 64 remains in position during the welding process. Thus, the battery module 20 may be moved such that the welding tool can access the weld points, while the extensions retain the bus bar bridge 64 in place.

Further still, the method 150 includes welding the bus bar bridge 64 to the appropriate components of the electrical path 120 (block 158). For example, the welding tool may heat weld points of the bus bar bridge 64 and/or press against the bus bar bridge 64 to weld the bus bar bridge 64 to the appropriate components of the electrical path 120. Additionally or alternatively, other welding processes may be used to weld the bus bar bridge 64 into place. Any welding process (e.g., ultrasonic welding, laser welding, diffusion welding) suitable for welding the bus bar bridge 64 to the appropriate components of the electrical path 120 is within the scope of present embodiments,

One or more of the disclosed embodiments, alone or in combination, may provide one or more technical effects useful in the manufacture of battery modules, and portiotis of battery modules. In general, embodiments of the present disclosure include a battery module having electrical paths extending between a group of electrically interconnected electrochemical cells and major terminals (e.g., module terminals) of the battery module. The electrical paths may each include one or more bus bar bridges. Snap-in extensions or guide walls of the housing may enable at least temporary retention of the bits bar bridge(s) before, during, and/or after the bus bar bridge(s) is/are welded into place in the electrical paths. The technical effects and technical problems in the specification are exemplary and are not limiting. It should be noted that the embodiments described in the specification may have other technical effects and can solve other technical problems.

## Claims

1. A lithium-ion (Li-ion) battery module (20), comprising:
- a group of electrically interconnected electrochemical cells (32);
- a battery module terminal (46) configured to be coupled to a load for powering the load;
- an electrical path extending between the group of electrically interconnected electrochemical cells (32) and the battery module terminal (46), wherein the electrical path comprises a bus bar bridge (64) coupled between the battery module terminal (46) and a plurality of bus bars (44) configured to electrically interconnect the group of electrically interconnected electrochemical cells (32); and
- a housing (30), wherein the group of electrically interconnected electrochemical cells (32) is disposed within the housing (30), and wherein the housing (30) comprises a pair of snap-in extensions (70) integrally formed with the housing (30), positioned along sides of the bus bar bridge (64) and configured to receive and retain the bus bar bridge (64) and to block movement of the bus bar bridge (64) in at least one direction,
wherein the bus bar bridge (64) is positioned proximate to the pair of snap-in extensions (70) such that a first weld point of the bus bar bridge (64) is exposed with sufficient clearance for access via a welding tool on a first side of the pair of snap-in extensions (70), and a second weld point of the bus bar bridge (64) is exposed with sufficient clearance for access via the welding tool on a second side of the pair of snap-in extensions (70) opposite to the first side.

2. The Li-ion battery module (20) of claim 1,
wherein the pair of snap-in extensions (70) is configured to block movement of the bus bar bridge (64) only along a transverse axis of the bus bar bridge (64).

3. The Li-ion battery module (20) of claim 1,
wherein the pair of snap-in extensions (70) is configured to block movement of the bus bar bridge (64) along a transverse axis of the bus bar bridge (64) and a longitudinal axis of the bus bar bridge (64) perpendicular to the transverse axis.

4. The Li-ion battery module (20) of claim 1,
wherein the pair of snap-in extensions (70) is configured to block movement of the bus bar bridge (64) along a transverse axis of the bus bar bridge (64), a longitudinal axis of the bus bar bridge (64) perpendicular to the transverse axis, and an axis along a thickness of the bus bar bridge (64) perpendicular to both the transverse and longitudinal axes.

5. The Li-ion battery module (20) of one of claims 1 to 4,
wherein the bus bar bridge (64) comprises an S-shape having a first base (80), a second base (82), and an S-bend (84) extending between the first base (80) and the second base (82).

6. The Li-ion battery module (20) of claim 5,
wherein the first base (80) of the bus bar bridge (64) extends between the snap-in extensions (70) of the pair of snap-in extensions (70).

7. The Li-ion battery module (20) of claim 5,
wherein the S-bend (84) extends between the snap-in extensions (70) of the pair of snap-in extensions (70).

8. The Li-ion battery module (20) of one of claims 5 to 7,
wherein the housing (30) comprises an additional pair of snap-in extensions (70) positioned along the sides of the bus bar bridge (64) and configured to retain the bus bar bridge (64) and to block movement of the bus bar bridge (64) in at least one direction, wherein the first base (80) of the bus bar bridge (64) extends between the snap-in extensions (70) of the pair of snap-in extensions (70), wherein the second base (82) of the bus bar bridge (64) extends between the additional snap-in extensions (70) of the additional pair of snap-in extensions (70), and wherein the pair of snap-in extensions (70) and the additional pair of snap-in extensions (70) extend in a first vertical direction substantially parallel to at least the portion of the S-bend (84) of the bus bar bridge (64).

9. The Li-ion battery module (20) of one of claims 1 to 8,
wherein each snap-in extension of the pair of snap-in extensions (70) comprises a hook (72) that extends toward the other snap-in extension of the pair of snap-in extensions (70) and over at least a portion of the bus bar bridge (64).

10. The Li-ion battery module (20) of claim 9,
wherein the hook (72) of each snap-in extension comprises a corresponding right, triangle having a base facing a first portion of the bus bar bridge (64) and parallel with the first portion of the bus bar bridge (64).

11. The Li-ion battery module (20) of one of claims 1 to 10,
wherein the group of electrically interconnected electrochemical cells (32) comprises a group of electrically interconnected prismatic lithium-ion (Li-ion) electrochemical cells (32).

12. The Li-ion battery module (20) of one of claims 1 to 11,
wherein the battery module comprises a shunt (60), and the bus bar bridge (64) is welded to the shunt (60).

13. The Li-ion battery module (20) of one of claims 1 to 12,
wherein the battery module (20) comprises a relay switch mechanism and the bus bar bridge (64) is coupled to a component of the relay switch mechanism.

14. The Li-ion battery module (20) of one of claims 1 to 13,
wherein the housing (30) and the pair of snap-in extensions (70) are plastic, and the pair of snap-in extensions (70) is integrally formed with the housing (30).

## Patentansprüche

1. Lithium-Ionen(Li-Ionen)-Batteriemodul (20), das Folgendes umfasst:
- eine Gruppe elektrisch miteinander verbundener elektrochemischer Zellen (32);
- einen Batteriemodulanschluss (46), der dazu ausgelegt ist, mit einer Last zum Versorgen der Last gekoppelt zu sein;
- einen elektrischen Pfad, der sich zwischen der Gruppe elektrisch miteinander verbundener elektrochemischer Zellen (32) und dem Batteriemodulanschluss (46) erstreckt, wobei der elektrische Pfad eine Sammelschienenbrücke (64) umfasst, die zwischen dem Batteriemodulanschluss (46) und mehreren Sammelschienen (44) gekoppelt ist, die dazu ausgelegt sind, die Gruppe elektrisch miteinander verbundener elektrochemischer Zellen (32) elektrisch miteinander zu verbinden; und
- ein Gehäuse (30), wobei die Gruppe elektrisch miteinander verbundener elektrochemischer Zellen (32) innerhalb des Gehäuses (30) angeordnet ist, und wobei das Gehäuse (30) ein Paar Rastverlängerungen (70) umfasst, die integral mit dem Gehäuse (30) ausgebildet sind, die entlang von Seiten der Sammelschienenbrücke (64) positioniert und dazu ausgelegt sind, die Sammelschienenbrücke (64) aufzunehmen und zu halten und eine Bewegung der Sammelschienenbrücke (64) in mindestens einer Richtung zu blockieren,
wobei die Sammelschienenbrücke (64) so in der Nähe des Paars Rastverlängerungen (70) positioniert ist, dass ein erster Schweißpunkt der Sammelschienenbrücke (64) mit ausreichendem Spielraum für einen Zugang über ein Schweißwerkzeug auf einer ersten Seite des Paars Rastverlängerungen (70) freiliegt, und ein zweiter Schweißpunkt der Sammelschienenbrücke (64) mit ausreichendem Spielraum für den Zugang über das Schweißwerkzeug auf einer zweiten Seite des Paars Rastverlängerungen (70) gegenüber der ersten Seite freiliegt.

2. Li-Ionen-Batteriemodul (20) nach Anspruch 1,
wobei das Paar Rastverlängerungen (70) dazu ausgelegt ist, eine Bewegung der Sammelschienenbrücke (64) nur entlang einer Querachse der Sammelschienenbrücke (64) zu blockieren.

3. Li-Ionen-Batteriemodul (20) nach Anspruch 1,
wobei das Paar Rastverlängerungen (70) dazu ausgelegt ist, eine Bewegung der Sammelschienenbrücke (64) entlang einer Querachse der Sammelschienenbrücke (64) und einer Längsachse der Sammelschienenbrücke (64) senkrecht zur Querachse zu blockieren.

4. Li-Ionen-Batteriemodul (20) nach Anspruch 1,
wobei das Paar Rastverlängerungen (70) dazu ausgelegt ist, eine Bewegung der Sammelschienenbrücke (64) entlang einer Querachse der Sammelschienenbrücke (64), einer Längsachse der Sammelschienenbrücke (64) senkrecht zur Querachse und einer Achse entlang einer Dicke der Sammelschienenbrücke (64) senkrecht zu sowohl der Quer- als auch der Längsachse zu blockieren.

5. Li-Ionen-Batteriemodul (20) nach einem der Ansprüche 1 bis 4,
wobei die Sammelschienenbrücke (64) eine S-Form mit einer ersten Basis (80), einer zweiten Basis (82) und einer S-Biegung (84) umfasst, die sich zwischen der ersten Basis (80) und der zweiten Basis (82) erstreckt.

6. Li-Ionen-Batteriemodul (20) nach Anspruch 5,
wobei sich die erste Basis (80) der Sammelschienenbrücke (64) zwischen den Rastverlängerungen (70) des Paars Rastverlängerungen (70) erstreckt.

7. Li-Ionen-Batteriemodul (20) nach Anspruch 5,
wobei sich die S-Biegung (84) zwischen den Rastverlängerungen (70) des Paars Rastverlängerungen (70) erstreckt.

8. Li-Ionen-Batteriemodul (20) nach einem der Ansprüche 5 bis 7,
wobei das Gehäuse (30) ein zusätzliches Paar Rastverlängerungen (70) umfasst, die entlang der Seiten der Sammelschienenbrücke (64) positioniert und dazu ausgelegt sind, die Sammelschienenbrücke (64) zu halten und eine Bewegung der Sammelschienenbrücke (64) in mindestens einer Richtung zu blockieren, wobei sich die erste Basis (80) der Sammelschienenbrücke (64) zwischen den Rastverlängerungen (70) des Paars Rastverlängerungen (70) erstreckt, wobei sich die zweite Basis (82) der Sammelschienenbrücke (64) zwischen den zusätzlichen Rastverlängerungen (70) des zusätzlichen Paars Rastverlängerungen (70) erstreckt, und wobei sich das Paar Rastverlängerungen (70) und das zusätzliche Paar Rastverlängerungen (70) in einer ersten vertikalen Richtung im Wesentlichen parallel zu zumindest dem Abschnitt der S-Biegung (84) der Sammelschienenbrücke (64) erstrecken.

9. Li-Ionen-Batteriemodul (20) nach einem der Ansprüche 1 bis 8,
wobei jede Rastverlängerung des Paars Rastverlängerungen (70) einen Haken (72) umfasst, der sich in Richtung der anderen Rastverlängerung des Paars Rastverlängerungen (70) und über zumindest einen Abschnitt der Sammelschienenbrücke (64) erstreckt.

10. Li-Ionen-Batteriemodul (20) nach Anspruch 9,
wobei der Haken (72) jeder Rastverlängerung ein entsprechendes rechtes Dreieck mit einer Basis umfasst, die einem ersten Abschnitt der Sammelschienenbrücke (64) zugewandt und parallel zu dem ersten Abschnitt der Sammelschienenbrücke (64) ist.

11. Li-Ionen-Batteriemodul (20) nach einem der Ansprüche 1 bis 10,
wobei die Gruppe elektrisch miteinander verbundener elektrochemischer Zellen (32) eine Gruppe elektrisch miteinander verbundener prismatischer elektrochemischer Lithium-Ionen(Li-Ionen)-Zellen (32) umfasst.

12. Li-Ionen-Batteriemodul (20) nach einem der Ansprüche 1 bis 11,
wobei das Batteriemodul einen Shunt (60) umfasst, und die Sammelschienenbrücke (64) mit dem Shunt (60) verschweißt ist.

13. Li-Ionen-Batteriemodul (20) nach einem der Ansprüche 1 bis 12,
wobei das Batteriemodul (20) einen Relaisschaltermechanismus umfasst und die Sammelschienenbrücke (64) mit einer Komponente des Relaisschaltermechanismus gekoppelt ist.

14. Li-Ionen-Batteriemodul (20) nach einem der Ansprüche 1 bis 13,
wobei das Gehäuse (30) und das Paar Rastverlängerungen (70) aus Kunststoff bestehen, und das Paar Rastverlängerungen (70) integral mit dem Gehäuse (30) ausgebildet ist.

## Revendications

1. Module de batterie lithium-ion (Li-ion) (20), comprenant :
- un groupe de cellules électrochimiques électriquement interconnectées (32) ;
- une borne de module de batterie (46) configurée pour être couplée à une charge pour alimenter la charge ;
- un trajet électrique s'étendant entre le groupe de cellules électrochimiques électriquement interconnectées (32) et la borne de module de batterie (46), le trajet électrique comprenant un pont de barre omnibus (64) couplé entre la borne de module de batterie (46) et une pluralité de barres omnibus (44) configurées pour électriquement interconnecter le groupe de cellules électrochimiques électriquement interconnectées (32) ; et
- un logement (30), dans lequel le groupe de cellules électrochimiques électriquement interconnectées (32) est disposé à l'intérieur du logement (30), et le logement (30) comprenant une paire d'extensions enfichables (70) formées d'un seul tenant avec le logement (30), positionnées le long de soudures du pont de barre omnibus (64) et configurées pour recevoir et retenir le pont de barre omnibus (64) et pour bloquer un déplacement du pont de barre omnibus (64) dans au moins une direction,
le pont de barre omnibus (64) étant positionné à proximité de la paire d'extensions enfichables (70) de telle sorte qu'un premier point de soudure du pont de barre omnibus (64) soit exposé avec un jeu suffisant pour un accès par l'intermédiaire d'un outil de soudure sur un premier côté de la paire d'extensions enfichables (70), et qu'un deuxième point de soudure du pont de barre omnibus (64) soit exposé avec un jeu suffisant pour un accès par l'intermédiaire de l'outil de soudure sur un deuxième côté de la paire d'extensions enfichables (70) opposé au premier côté.

2. Module de batterie Li-ion (20) selon la revendication 1,
dans lequel la paire d'extensions enfichables (70) est configurée pour bloquer un déplacement du pont de barre omnibus (64) uniquement le long d'un axe transversal du pont de barre omnibus (64).

3. Module de batterie Li-ion (20) selon la revendication 1,
dans lequel la paire d'extensions enfichables (70) est configurée pour bloquer un déplacement du pont de barre omnibus (64) le long d'un axe transversal du pont de barre omnibus (64) et un axe longitudinal du pont de barre omnibus (64) perpendiculaire à l'axe transversal.

4. Module de batterie Li-ion (20) selon la revendication 1,
dans lequel la paire d'extensions enfichables (70) est configurée pour bloquer un déplacement du pont de barre omnibus (64) le long d'un axe transversal du pont de barre omnibus (64), un axe longitudinal du pont de barre omnibus (64) perpendiculaire à l'axe transversal, et un axe le long d'une épaisseur du pont de barre omnibus (64) perpendiculaire à la fois aux axes transversal et longitudinal.

5. Module de batterie Li-ion (20) selon l'une des revendications 1 à 4,
dans lequel le pont de barre omnibus (64) comprend une forme en S ayant une première base (80), une deuxième base (82), et un coude en S (84) s'étendant entre la première base (80) et la deuxième base (82).

6. Module de batterie Li-ion (20) selon la revendication 5,
dans lequel la première base (80) du pont de barre omnibus (64) s'étend entre les extensions enfichables (70) de la paire d'extensions enfichables (70).

7. Module de batterie Li-ion (20) selon la revendication 5,
dans lequel le coude en S (84) s'étend entre les extensions enfichables (70) de la paire d'extensions enfichables (70).

8. Module de batterie Li-ion (20) selon l'une des revendications 5 à 7,
dans lequel le logement (30) comprend une paire supplémentaire d'extensions enfichables (70) positionnées le long des côtés du pont de barre omnibus (64) et configurées pour retenir le pont de barre omnibus (64) et pour bloquer un déplacement du pont de barre omnibus (64) dans au moins une direction, dans lequel la première base (80) du pont de barre omnibus (64) s'étend entre les extensions enfichables (70) de la paire d'extensions enfichables (70), dans lequel la deuxième base (82) du pont de barre omnibus (64) s'étend entre les extensions enfichables supplémentaires (70) de la paire supplémentaire d'extensions enfichables (70), et la paire d'extensions enfichables (70) et la paire supplémentaire d'extensions enfichables (70) s'étendant dans une première direction verticale substantiellement parallèle à au moins la portion du coude en S (84) du pont de barre omnibus (64).

9. Module de batterie Li-ion (20) selon l'une des revendications 1 à 8,
dans lequel chaque extension enfichable de la paire d'extensions enfichables (70) comprend un crochet (72) qui s'étend vers l'autre extension enfichable de la paire d'extensions enfichables (70) et sur au moins une portion du pont de barre omnibus (64).

10. Module de batterie Li-ion (20) selon la revendication 9,
dans lequel le crochet (72) de chaque extension enfichable comprend un triangle rectangle correspondant ayant une base faisant face à une première partie du pont de barre omnibus (64) et parallèle à la première portion du pont de barre omnibus (64).

11. Module de batterie Li-ion (20) selon l'une des revendications 1 à 10,
dans lequel le groupe de cellules électrochimiques électriquement interconnectées (32) comprend un groupe de cellules électrochimiques (32) lithium-ion (Li-ion) prismatiques électriquement interconnectées.

12. Module de batterie Li-ion (20) selon l'une des revendications 1 à 11,
dans lequel le module de batterie comprenant un shunt (60), et le pont de barre omnibus (64) étant soudé au shunt (60).

13. Module de batterie Li-ion (20) selon l'une des revendications 1 à 12, dans lequel le module de batterie (20) comprend un mécanisme de commutation de relais et le pont de barre omnibus (64) est couplé à un composant du mécanisme de commutation de relais.

14. Module de batterie Li-ion (20) selon l'une des revendications 1 à 13, dans lequel le logement (30) et la paire d'extensions enfichables (70) sont en plastique, et la paire d'extensions enfichables (70) est formée d'un seul tenant avec le logement (30).
